# EUROPEAN PATENT SPECIFICATION

(11) **EP 0 506 450 B1**
(45) Date of publication and mention of the grant of the patent: **23.01.2002**
(21) Application number: 92302703.1
(22) Date of filing: 27.03.1992
(51) Int. Cl.: H01L 29/872, H01L 21/329

(54) **A method of manufacturing a Schottky barrier diode**
Herstellungsverfahren für eine Schottky-Diode
Methode de fabrication d'une diode à barrière Schottky

(30) Priority: 28.03.1991 JP 10503091; 28.06.1991 JP 18542791
(43) Date of publication of application: 30.09.1992
(73) Proprietor: MURATA MANUFACTURING CO., LTD., Nagaokakyo-shi,Kyoto (JP)
(72) Inventor: Ariyoshi, Hisashi, c/o Murata Manufact. Co., Ltd., Nagaokakyo-shi, Kyoto (JP); Sueyoshi, Masaaki, c/o Murata Manufact. Co., Ltd., Nagaokakyo-shi, Kyoto (JP); Sakamoto, Kouichi, c/o Murata Manufact. Co., Ltd., Nagaokakyo-shi, Kyoto (JP); Fukuda, Susumu, c/o Murata Manufact. Co., Ltd., Nagaokakyo-shi, Kyoto (JP)
(74) Representative: Milhench, Howard Leslie

(56) References cited:
- EP-A- 0 134 456
- EP-A- 0 147 893
- US-A- 4 982 260
- PATENT ABSTRACTS OF JAPAN vol. 9, no. 230 (E-343)17 September 1985 & JP-A-60 086 873 (HITACHI SEISAKUSHO KK) 16 May 1985
- 1982 IEEE MTT-S INTERNATIONAL MICROWAVE SYMPOSIUM DIGEST. JUNE 15-17 HYATT REGENCY DALLAS, TEXAS pages 24 - 26 S. J. J. TENG ET AL 'THE GAP DIODE: A NEW GAP FREQUENCY MIXER AND DETECTOR'
- PATENT ABSTRACTS OF JAPAN vol. 15, no. 159 (E-1059)22 April 1991 & JP-A-03 032 062 (SHARP CORP) 12 February 1991
- PATENT ABSTRACTS OF JAPAN vol. 012, no. 474 (E-692)12 December 1988 & JP-A-63 193 571 (NEC CORP) 10 August 1988

## Description

The present invention relates to a method of manufacturing a Schottky barrier diode, and more particularly though not exclusively, to a method of manufacturing a Schottky barrier diode having improved rectifying characteristics.

### Description of the Background Art

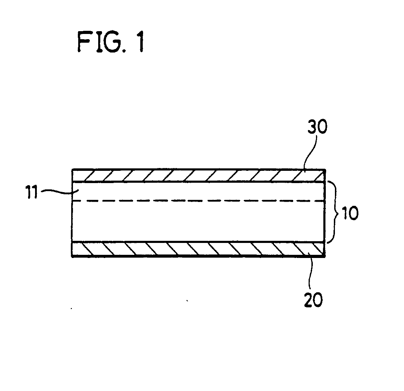

Fig. 1 schematically shows a sectional view of a conventional Schottky barrier diode. Referring to Fig. 1, this diode has an ohmic metal electrode 20 and a Schottky metal electrode 30 provided at the bottom side and the top side, respectively, of the main surface of a semiconductor substrate 10 having a plate configuration.

In a Schottky barrier diode utilizing rectifying characteristics by a metal/semiconductor junction, a depletion layer is formed in the semiconductor in the proximity of the metal/semiconductor junction interface to generate a built-in voltage so that the Fermi level in both sides of the metal/semiconductor junction interface is identical. Since there are no charge carriers such as electrons and holes in depletion layer 11, it is necessary to lower the potential barrier height of depletion layer 11 by applying a forward voltage opposing the built-in voltage in order to obtain a forward current between Schottky electrode 30 and ohmic electrode 20. The forward voltage applied to lower the potential barrier height of depletion layer 11 is equivalent to the threshold voltage of the diode. Therefore, a forward direction voltage greater than the threshold voltage must be applied to obtain a flow of forward current.

Particularly, a Schottky barrier diode employing a GaAs substrate has a built-in voltage greater than that of a diode employing a silicon substrate. This built-in voltage does not substantially change even if the type of the metal of the electrode is changed. This means that a Schottky barrier diode employing a GaAs substrate has rectifying characteristics in the forward direction inferior to that of one employing a silicon substrate.

A typical threshold voltage of a Schottky barrier diode using a GaAs substrate is 0.6V. A forward voltage exceeding the threshold voltage of 0.6V must be applied to establish a flow of forward current. If a forward voltage of 0.9V, for example, is applied to establish a flow of forward current I, 0.6V x I is consumed as power loss. Two thirds of the entire consumed power 0.9V x I is spent as the power loss by the threshold voltage to be converted into undesired heat.

JP-A-60086873 describes a semiconductor device comprising Schottky electrodes discontinuously formed partially coming into contact with an n type semiconductor layer. An anode layer is formed over the Schottky electrodes and makes an ohmic contact with the n layer.

In 1982 IEEE MTT-S International Microwave Symposium Digest pages 24-26 there is described a device comprising an n-type epitaxial layer of GaAs on an n⁺ conducting substrate. Stripes of a Schottky metal are deposited either on the surface or in notches in the epi-layer. Thus, a gap exists between adjacent Schottky barrier regions exposing the n-layer. An ohmic contact is established over the entire surface connecting the Schottky barrier regions and the n-layer filled gap in parallel. The I-V characteristic of the device is controlled by the gap between adjacent Schottky barrier regions.

EP-A-0134456 describes a high speed semiconductor pinch rectifier which attains low forward voltage drop and low reverse leakage current by utilizing depletion region pinch off conduction channels in a high-resistivity region. In a preferred form the pinch rectifier utilizes a Schottky barrier contact so as to facilitate device fabrication.

### SUMMARY OF THE INVENTION

In view of the foregoing, an object of the present invention is to provide a method of manufacturing a Schottky barrier diode having improved rectifying characteristics.

According to the invention there is provided a method of manufacturing a Schottky barrier diode, said method comprising: forming an ohmic metal electrode on a first region of a semiconductor substrate; forming a Schottky metal electrode on a second region spaced apart from said first region on said semiconductor substrate; wherein said step of forming the Schottky metal electrode comprises forming at least one ohmic portion in ohmic contact with said substrate and forming a Schottky metal portion in electrical connection with said at least one ohmic portion characterised in that said step of forming said Schottky metal portion is carried out after said step of forming said at least one ohmic portion such that said Schottky metal portion covers said at least one ohmic portion.

Thus, a Schottky metal electrode is easily formed that includes an ohmic contact metal film covered by a Schottky contact metal film with reliable electrical contact therebetween.

The above and further features of the present invention are set forth in the appended claims, and should become clearer from consideration of the following detailed description of embodiments of the invention given with reference to the accompanying drawings.

### BRIEF DESCRIPTION OF THE DRAWINGS

Fig. 1 is a sectional view of a conventional Schottky barrier diode.

Fig. 2 is a perspective view of a Schottky barrier diode.

Fig. 3A and 3B are sectional views of the diode of Fig. 2.

Figs. 4 - 6 are sectional views of Schottky barrier diodes.

Figs. 7A and 7B are sectional views of the diode of Fig. 6 for describing the operation thereof.

Fig. 8 is a sectional view of a Schottky barrier diode.

Fig. 9 is a sectional view of a Schottky, barrier diode.

Figs. 10A and 10B are sectional views of a Schottky barrier diode.

Figs. 11 and 12 are sectional views of Schottky barrier diodes.

Fig. 13 is a graph showing rectifying characteristics of the diode illustrated in Fig. 8.

Figs. 14A - 14C are sectional views for describing the manufacturing method of a Schottky barrier diode according to an embodiment of the present invention.

Figs. 15A and 15B are sectional views for describing the method of manufacturing a Schottky barrier diode according to an embodiment of the present invention.

In the drawings, corresponding components have identical reference numerals denoted thereto.

### DESCRIPTION OF THE PREFERRED EMBODIMENTS

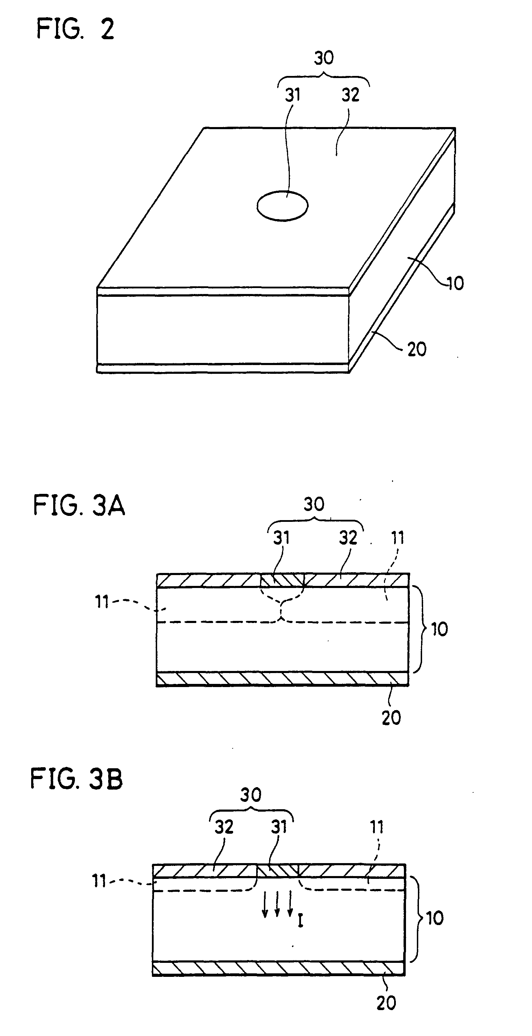

A Schottky barrier diode will be described hereinafter with reference to Figs. 2, 3A, and 3B. An ohmic electrode 20 is provided at the bottom side of the main surface of a semiconductor substrate 10 such as a GaAs substrate. A small disc-like (for example, approximately 0.5µm in diameter) ohmic contact metal film 31 is provided in the center portion on the top side of the main surface of semiconductor substrate 10. A Schottky contact metal film 32 is provided on the surface of substrate 10, surrounding ohmic contact metal film 31 continuously. The electrically connected ohmic contact metal film 31 and Schottky contact metal film 32 form Schottky electrode 30. Although the shape of ohmic contact metal film 31 is not limited to a disc, the area thereof is surrounded by Schottky electrode 30. It is to be noted that ohmic contact metal film 31 may be covered by Schottky contact metal film 32.

When voltage is not applied or reverse voltage is applied across Schottky electrode 30 and ohmic electrode 20 in this Schottky barrier diode, depletion layer 11 extends from the Schottky contact interface in semiconductor substrate 10, as shown in Fig. 3A. Depletion layer 11 spreads in the horizontal direction of semiconductor substrate 10, as well as in the depth direction. This means that not only the region beneath Schottky contact metal film 32, but also the region beneath ohmic contact metal film 31 is screened by depletion layer 11. As a result, the reverse current between Schottky electrode 30 and ohmic electrode 20 is blocked by depletion layer 11.

The extension of depletion layer 11 in the horizontal direction is not so great. In order to reliably block reverse current between Schottky electrode 30 and ohmic electrode 20, ohmic contact metal film 31 must be small enough to be reliably screened by the extension of depletion layer 11 in the horizontal direction.

In the case where forward voltage is applied between Schottky electrode 30 and ohmic electrode 20, depletion layer 11 beneath the Schottky contact interface is reduced, as shown in Fig. 3B. Depletion layer 11 does not exist in the region between ohmic contact metal film 31 and ohmic electrode 20 so that a current path can be formed. Thus, the application of a forward voltage causes the flow of forward current I between ohmic contact metal film 31 and ohmic electrode 20. The absence of depletion layer 11 in the ohmic region where forward current I flows suppresses the generation of wasteful voltage drop caused by depletion layer 11. This means that forward current I of a sufficient level can be obtained by a small forward voltage to achieve superior rectifying characteristics.

In order to prevent reverse current adequately, ohmic contact metal film 31 must be small enough to be screened by the extension of depletion layer 11 in the horizontal direction when the voltage applied to the diode is 0V. However, a considerably small ohmic contact metal film 31 is not preferred to facilitate the flow of forward current. This is because a greater forward voltage will be required to eliminate the spread of depletion layer 11 in the horizontal direction under the region beneath ohmic contact metal film 31 to form a current path. The area of ohmic contact metal film 31 is set to an optimum value that can ensure the block of reverse current and that can establish forward current by a small forward voltage.

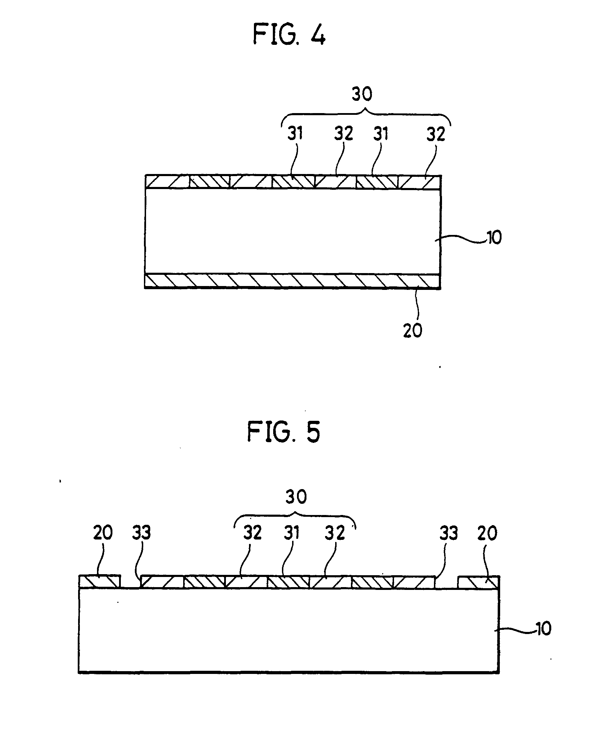

Referring to Fig. 4, a Schottky barrier diode is shown. This diode is similar to that of Fig. 3A, except for a plurality of ohmic contact metal films 31 included in Schottky electrode 30. The diode of Fig. 4 can have the forward current density flowing per ohmic contact metal film 31 reduced with respect to the diode of Figure 3A. Therefore, if the forward current densities are made equivalent to that of the diode of Figure 3A, a flow of a greater forward current can be established for the entire diode. Each of the plurality of ohmic contact metal films 31 is not limited to a disc shape, and may be a rectangular, a polygon, a narrow stripe, a thin ring, or a narrow stripe network.

Fig. 5 shows a Schottky barrier diode. This diode is similar to that of Fig. 4, except that ohmic electrode 20 and Schottky electrode 30 are provided on the same main surface of semiconductor substrate 10. More specifically, ohmic electrode 20 is separated from Schottky electrode 30 on the top side main surface of semiconductor substrate 10. Ohmic electrode 20 is formed in a ring configuration to surround Schottky electrode 30. On applying forward voltage to this diode, forward current flows across the plurality of ohmic regions 31 in Schottky electrode 30 and a ring-shaped ohmic electrode 20 through the upper layer portion of semiconductor substrate 10. In this embodiment, the ring-shaped ohmic electrode 20 provided along the peripheral edge 33 of Schottky electrode 30 serves as a guard ring to prevent the generation of voltage breakdown at peripheral edge 33 of Schottky electrode 30.

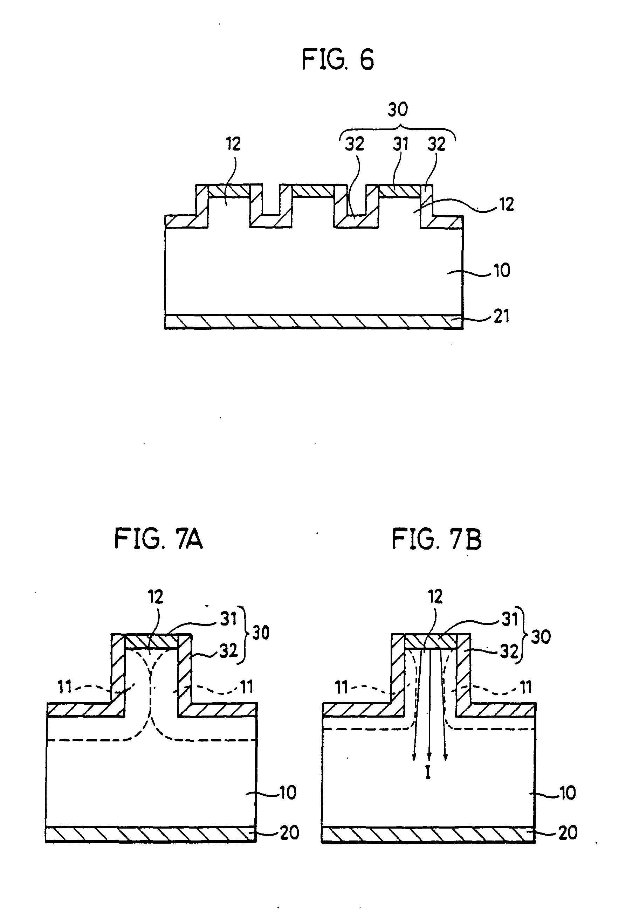

Fig. 6 shows a Schottky diode. This diode is similar to that of Fig. 4, except that a plurality of projections 12 are formed at the upper side of semiconductor substrate 10. The plurality of projections 12 may be formed by etching semiconductor substrate 10, or by deposition utilizing semiconductor crystal growth and the like. The top face of each projection 12 is covered with ohmic contact metal film 31. The surface of substrate 10 excluding projection 12 and the sidewall of projection 12 are covered with Schottky contact metal film 32.

In the Schottky barrier diode of Fig. 6, depletion layer 11 extends from the sidewall of projection 12 inwardly by the influence of Schottky contact metal film 32 formed on the sidewall of projection 12. Therefore, when reverse voltage is applied, ohmic contact metal film 31 formed on the surface of projection 12 can reliably be screened by depletion layer 11 to ensure the block of reverse current.

When forward voltage is applied, the depletion layer 11 along the sidewall of projection 12 is thinner, as shown in Fig. 7B. Therefore, forward current I can flow between ohmic contact metal film 31 and ohmic electrode 20.

Although the sidewall of the projection 12 is covered with Schottky contact metal film 32 in the diode of Fig. 6, the sidewall of projection 12 may be covered with ohmic contact metal film 31 instead. This is because the depletion layer can extend in the horizontal direction from the edge of Schottky contact metal film 32 in the proximity of the root of projection 12 to screen projection 12.

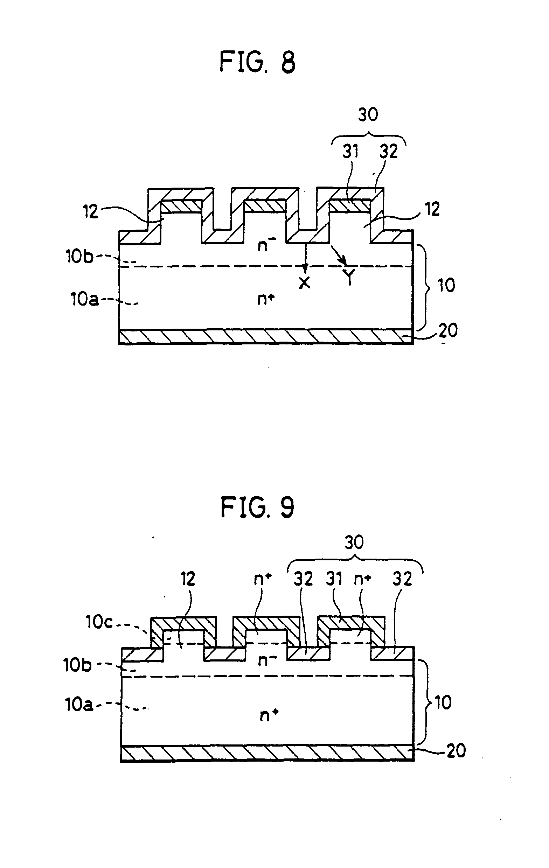

Fig. 8 shows a Schottky barrier diode. The diode is similar to that of Fig. 6 having a plurality of projections formed in the upper side of semiconductor substrate 10. However, the semiconductor substrate 10 of Fig. 8 includes a first layer 10a of a high impurity concentration (n⁺), and a second layer 10b of low impurity concentration (n⁻) provided thereupon. Projection 12 is formed in the region of n⁻ layer 10b. Therefore, a depletion layer easily spreads in projection 12 when reverse voltage is applied to block reverse current in a more reliable manner.

Fig. 9 shows a Schottky barrier diode, the manufacturing method of which is outside the scope of the appended claims. This diode has a semiconductor substrate 10 which further includes a third party 10c of high impurity concentration (n⁺- formed on second layer 10b. The root portion of projection 12 is located in second layer 10b. The third layer 10c is located at the upper portion of projection 12. Not only the top surface, but also at least one portion of the sidewall of projection 12 is covered with ohmic contact metal film 31.

When reverse voltage is applied to such a diode, a depletion layer easily expands in the proximity of the root of projection 12 since that portion is formed of an n⁻ layer 10b. Thus, the reverse current is reliably blocked. When forward voltage is applied, the flow of forward current between ohmic contact metal film 31 and ohmic electrode 20 is facilitated due to a smaller electric resistance since the upper portion of projection 12 is formed of an n⁺ layer 10c.

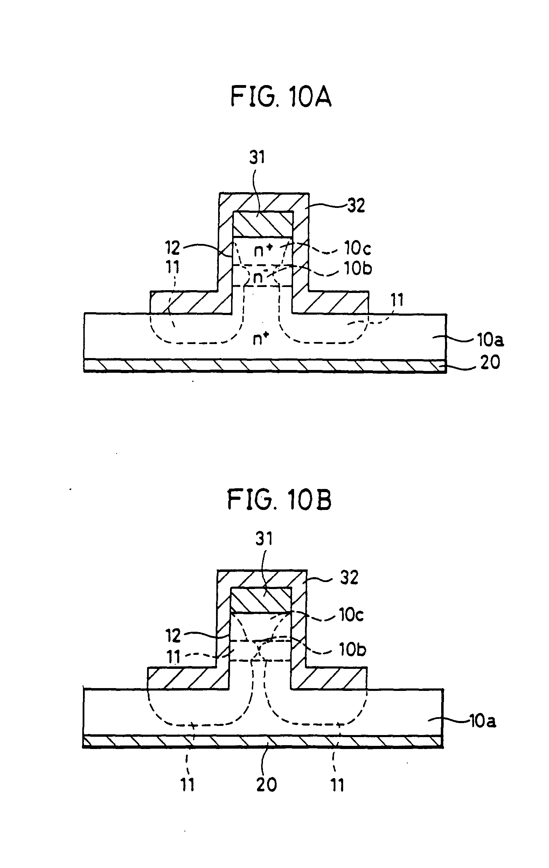

Figs. 10a and 10b show a Schottky barrier diode. This diode has a relatively thin n⁻ layer 10b which is located in the intermediate level of projection 12. Fig. 10A shows the state of depletion layer 11 when forward voltage is applied. The application of forward voltage results in a depletion layer 11 which is thinner along Schottky contact metal film 32 on the sidewall of projection 12. Because n⁻ layer 10b is thin between ohmic contact metal film 31 and ohmic electrode 20, the forward current can easily flow between them through the other n⁺ regions.

Fig. 10B shows the state of depletion layer 11 when reverse voltage is applied. The application of reverse voltage results in a depletion layer which is thicker along Schottky contact metal film 32 at the sidewall of projection 12. The spread of depletion layer 11 in the horizontal direction is particularly noticeable in n⁻ layer 10b due to the low impurity concentration of second layer 10b. Ohmic contact metal film 31 is completely screened by depletion layer 11 extending in n⁻ layer 10b so that reverse current is blocked between ohmic contact metal film 31 and ohmic electrode 20.

Projection 12 may be formed to have a width of 1µm and a height of 3µm. The n⁻ layer 10b in projection 12 may be formed to have a thickness of approximately 1µm with an impurity concentration of approximately 5x10¹³/cm³. The other regions in projection 12 excluding n⁻ layer 10b may have an impurity concentration of approximately 1x10¹⁸/cm³.

There may be a continuous change in impurity concentration in projection 12. For example, the impurity concentration may be approximately 1x10¹⁸/cm³ in the proximity of the upper portion of projection 12 to be reduced in a gauss distribution manner to approximately 5x10¹³/cm³ as a function of depth. With this impurity distribution, the flow of forward current is facilitated by the high impurity concentration at the upper portion of projection 12, while the expansion of depletion layer 11 is facilitated by the low impurity concentration at the bottom portion.

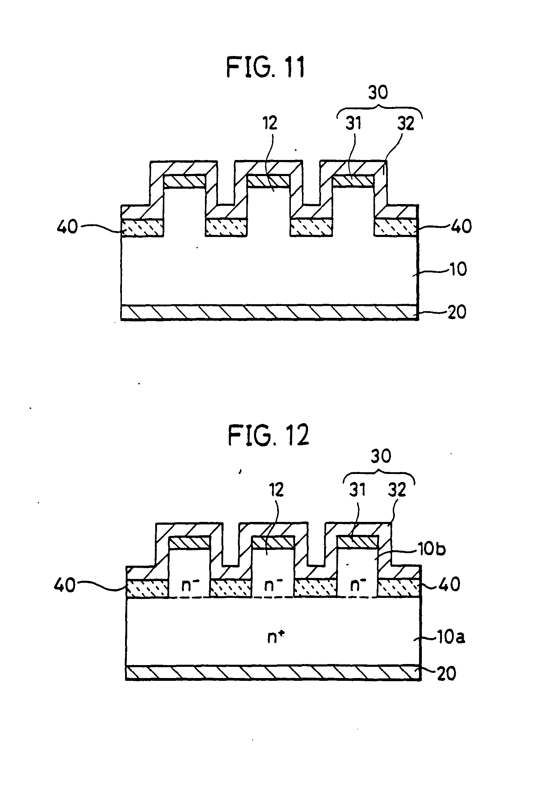

Fig. 11 shows a Schottky barrier diode. This diode is similar to that of Fig. 6, except that an insulation layer or a high resistance layer 40 is inserted between the surface of semiconductor substrate 10 excluding projection 12 and Schottky contact metal film 32. The insulation layer or high resistance layer 40 serves to reliably prevent reverse current between ohmic electrode 20 and Schottky contact metal film 32.

Fig. 12 shows a Schottky barrier diode. This diode is similar to that of Fig. 11, except that projection 12 is formed of an n⁻ layer 10b of low impurity concentration. For example, projection 12 can take an impurity concentration of approximately 10¹³ - 10¹⁶/cm³, while the portion of the semiconductor substrate other than projection 12 may take an impurity concentration of approximately 10¹⁸/cm³.

In a diode as shown in Fig. 8 that does not have such an insulation layer 40 formed therein, there may be a leakage current caused by a punch through phenomenon, as shown by arrow X, when the thickness of the depletion layer beneath Schottky contact metal film 32 is not sufficient. Furthermore, there may be a breakdown caused by edge effect in the bending portion of Schottky contact metal film 32, as shown by arrow Y. The insulation layer 40 of Fig. 12 serves to prevent leakage current by punch through or breakdown by edge effect.

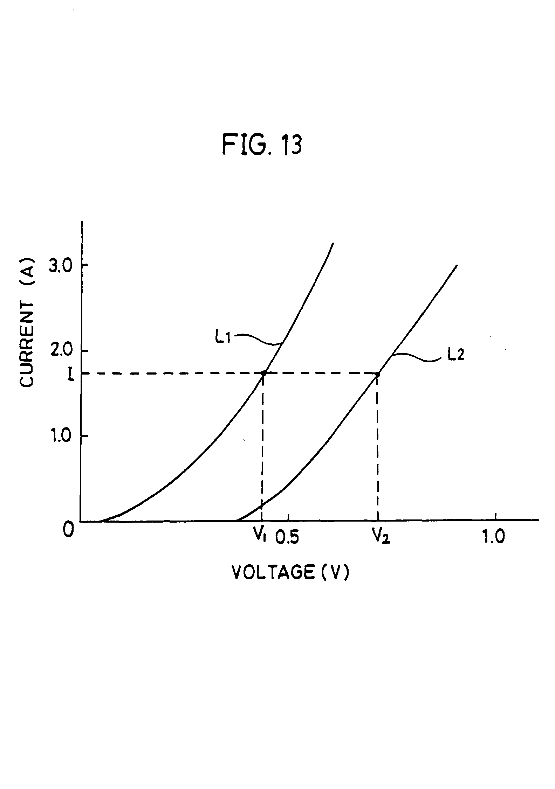

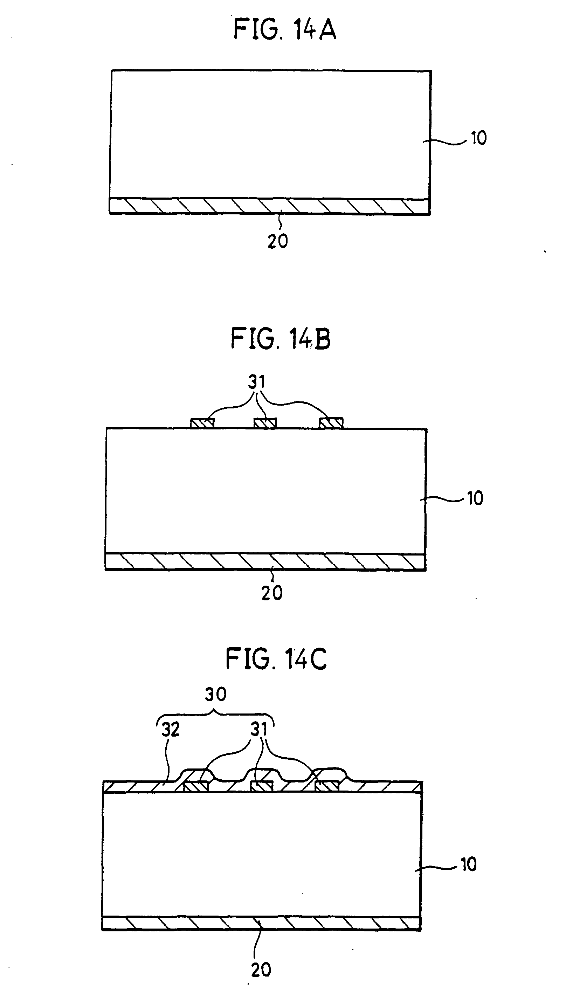

The graph of Fig. 13 shows the comparison of rectifying characteristics between the Schottky barrier diode manufactured according to an embodiment of the present invention and the conventional Schottky barrier diode. Referring to Fig. 13, the abscissa represents forward voltage (V), and the ordinate represents forward current (A). Curves L1 and L2 show the forward voltage/current characteristics of the Schottky barrier diode manufactured according to the embodiment and that of the conventional Schottky barrier diode of Fig.1 respectively. The rectangle area related to each of curves L1, L2 in Fig. 14 corresponds to the power loss V₁I or V₂I consumed at a given current value I by the relevant diode. This power loss is converted into heat to raise the temperature of the diode.

It can be appreciated from the comparison of curves L1 and L2 of Fig. 13 that the Schottky barrier diode of Fig. 8 has a power loss considerably smaller than that of the conventional Schottky barrier diode of Fig. 1. It can be said that the Schottky barrier diode manufactured according to the embodiment of the invention has superior rectifying characteristics.

A method of manufacturing a Schottky barrier diode according to an embodiment of the present invention will now be described with reference to Figs. 14A-14C. Referring to Fig. 14A, ohmic electrode 20 is formed at the bottom side of the main surface of semiconductor substrate 10 such as of a GaAs substrate. Although it is economical to form ohmic electrode 20 at the earlier stage of manufacture, it may be formed in the middle or at the last step of the manufacturing process. Referring to Fig. 14B, a plurality of ohmic contact metal films 31 are formed on the top side of the main surface of semiconductor substrate 10. The width of each ohmic contact metal film 31 is set to be not more than two times the depletion layer thickness in the horizontal direction when the voltage is not applied. Referring to Fig. 14C, Schottky contact metal film 32 is formed by vapor deposition and the like on the top face of the main surface of semiconductor substrate 10 while covering ohmic contact metal film 31. Thus, ohmic contact metal film 31 and Schottky contact metal film 32 attain an electrically conductive state. Although ohmic contact metal film 31 is covered with Schottky contact metal film 32, the ohmic contact at the interface of ohmic contact metal film 31 and semiconductor substrate 10 is retained.

The method of manufacturing the Schottky barrier diode of Figs. 14A - 14C does not require the critical registration (more specifically, within the range of horizontal depletion layer thickness) of ohmic contact metal film 31 and the mask for Schottky contact metal film formation needed in the manufacturing of the diode illustrated in Fig. 2, nor the critical registration of Schottky contact metal film 31 and ohmic contact metal film 32. There is no possibility of incomplete electrical conduction caused by a gap between ohmic contact metal film 31 and Schottky contact metal film 32. Schottky electrode 30 can be formed precisely and easily.

The depletion layer thickness is related to the impurity concentration in the proximity of the surface of semiconductor substrate 10. For example, if the impurity concentration is approximately 1x10¹⁵/cm³, the depletion layer thickness is approximately 1.5µm. Therefore, the width of ohmic contact metal film 30 can easily be controlled to be not more than two times (3.0µm) the depletion layer thickness. Even if the impurity concentration is as high as 5x10¹⁵/cm³, the depletion layer thickness is approximately 0.5µm. Therefore, a double depletion layer thickness is approximately 1µm, and an ohmic contact metal film 31 can easily be formed.

It is to be understood that ohmic contact metal film 31 may be covered with Schottky contact metal film 32 in the embodiments of Figs. 4, 5, 6, and 9.

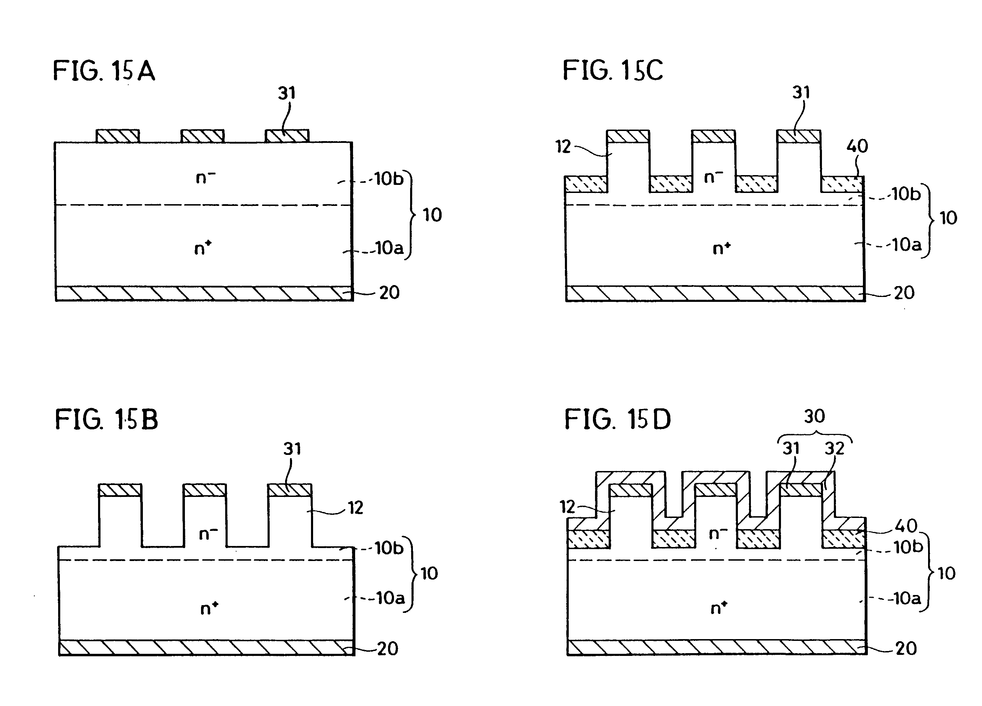

Figs. 15A - 15D shows a method of manufacturing a Schottky barrier diode according to an additional embodiment of the present invention.

Referring to Fig. 15A, semiconductor substrate 10 comprises a high concentration impurity layer (n⁺ layer) 10a, and a low impurity concentration layer (n⁻ layer) 10b thereupon. Ohmic electrode 20 is formed at the bottom side of the main surface of substrate 10. A plurality of ohmic contact metal films 31 are formed on the top side of the main surface of substrate 10.

Referring to Fig. 15B, the surface of substrate 10 excluding the region which is covered by a plurality of ohmic contact metal films 31 is etched anisotropically by reactive ion etching to form a plurality of projections 12. Each projection 12 may be formed having a width of 0.5 - 1µm and a height of 3 - 5µm.

Referring to Fig. 15C, an insulation film or a high resistance film 40 such as of silicon nitride or silicon dioxide film is deposited by CVD method on the surface of substrate 10 excluding the plurality of projections 12.

Referring to Fig. 15D, ohmic contact metal film 31, the sidewall of projection 12, and insulation film 40 are covered with Schottky contact metal film 32 to implement a Schottky electrode 30 comprising ohmic contact metal film 31 and Schottky contact metal film 32.

According to the manufacturing method of Figs. 15A-15D of a Schottky barrier diode, Schottky contact metal film 32 that is electrically connected to ohmic contact metal film 31 and that covers the sidewall of projection 12 can easily be formed without the need of any mask.

Although the present invention has been described and illustrated in detail, it is clearly understood that the same is by way of illustration and example only and is not to be taken by way of limitation, the scope of the present invention being limited only by the terms of the appended claims.

## Claims

1. A method of manufacturing a Schottky barrier diode, said method comprising:
forming an ohmic metal electrode (20) on a first region of a semiconductor substrate (10);
forming a Schottky metal electrode (30) on a second region spaced apart from said first region on said semiconductor substrate (10);
wherein said step of forming the Schottky metal electrode (30) comprises forming at least one ohmic portion (31) in ohmic contact with said substrate (10) and forming a Schottky metal portion (32) in electrical connection with said at least one ohmic portion (31) **characterised in that** said step of forming said Schottky metal portion (32) is carried out after said step of forming said at least one ohmic portion (31) such that said Schottky metal portion (32) covers said at least one ohmic portion (31).

2. A method according to claim 1, wherein said substrate (10) comprises a plate-like configuration, and wherein
said first region is located on a first main surface of said substrate (10), and
said second region is located on a second main surface of said substrate (10).

3. A method according to claim 1, wherein
said substrate (10) comprises a plate-like configuration, and
said first and second regions are located on the same main surface of said substrate (10).

4. A method according to claim 3, wherein said ohmic electrode (20) is formed to surround said Schottky electrode (30) to serve as a guard ring.

5. The method according to any preceding claim wherein said step of forming a Schottky metal electrode (30) further comprises:
etching anisotropically said second region of said substrate (10) excluding the region covered by said at least one ohmic portion (31) to form at least one projection (12) of said substrate (10) beneath said at least one ohmic portion (31) prior to forming said Schottky metal portion (32); said step of forming a Schottky metal portion (32) subsequently being carried out to cover said second region and to cover said ohmic portion (31).

6. A method according to claim 5, wherein said at least one projection (12) includes a transversing layer (10b) of relatively low concentration of a conductivity type determining impurity.

7. A method according to claim 5, wherein said at least one projection (12) has a relatively low concentration of a conductivity type determining impurity.

8. A method according to claim 5, wherein said at least one projection (12) and a semiconductor layer (10b) from the interface of said substrate (10) and said Schottky electrode (30) to a prescribed depth have a relatively low concentration of a conductivity type determining impurity in said second region.

9. The method according to any of claims 5 to 8 wherein said step of forming a Schottky metal electrode (30) further comprises:
forming a high-resistance layer (40) or an insulating layer (40) covering said second region excluding said at least one projection region (12) on said substrate (10) prior to forming said Schottky metal portion (32),
said step of forming a Schottky metal portion (32) subsequently being carried out to cover said second region and also to cover said ohmic portion (31) and said high-resistance or insulating layer (40).

## Patentansprüche

1. Verfahren zur Herstellung einer Schottky-Diode, das aufweist:
Bilden einer ohmschen Metallelektrode (20) auf einem ersten Bereich eines Halbleitersubstrats (10);
Bilden einer Schottky-Metallelektrode (30) auf einem zweiten Bereich des Halbleitersubstrats (10), der vom ersten Bereich beabstandet ist;
wobei der Schritt, der die Schottky-Metallelektrode bilden, die Bildung wenigstens eines ohmschen Abschnitts (31) in ohmschen Kontakt mit dem Substrat (10) und die Bildung eines Schottky-Metallabschnitts (32) in elektrischer Verbindung mit dem mindestens einen ohmschen Abschnitt (31) aufweist, **dadurch gekennzeichnet, dass** der Schritt, der den Schottky-Metallabschnitt (32) bildet, nach dem Schritt, der den wenigstens einen ohmschen Abschnitt (31) bildet, ausgeführt wird, so dass der Schottky-Metallabschnitt (32) den wenigstens einen ohmschen Abschnitt (31) bedeckt.

2. Verfahren nach Anspruch 1, bei dem das Substrat (10) einen plattenförmigen Aufbau aufweist und bei dem der erste Bereich auf einer ersten Hauptfläche des Substrats (10) liegt und der zweite Bereich auf einer zweiten Hauptfläche des Substrats (10) liegt.

3. Verfahren nach Anspruch 1, bei dem das Substrat (10) einen plattenförmigen Aufbau aufweist und der erste und zweite Bereich auf derselben Hauptfläche des Substrats (10) liegen.

4. Verfahren nach Anspruch 3, bei dem die ohmsche Elektrode (20) die Schottky-Elektrode (30) umgebend gebildet ist und als Schutzring dient.

5. Verfahren nach einem der vorangehenden Ansprüche, bei dem der Schritt, der die Schottky-Metallelektrode (30) bildet, weiter aufweist:
anisotropes Ätzen des ersten Bereichs des Substrats (10) mit Ausnahme des von dem wenigstens einen ohmschen Abschnitt (31) bedeckten Bereichs, um wenigstens einen Vorsprung (12) des Subtrats (10) unter dem wenigsten einen ohmschen Abschnitt (31) vor der Bildung des Schottky-Metallabschnitts (32) zu bilden; wobei der Schritt, der einen Schottky-Metallabschnitt (32) bildet, darauffolgend ausgeführt wird, um den zweiten Bereich und den ohmschen Abschnitt (31) zu bedecken.

6. Verfahren nach Anspruch 5, bei dem der wenigstens eine Vorsprung (12) eine Transversallage (10b) verhältnismäßig geringer Konzentration einer einen Leitungstyp bestimmenden Verunreinigung enthält.

7. Verfahren nach Anspruch 5, bei dem der wenigstens eine Vorsprung (12) eine verhältnismäßig niedrige Konzentration einer einen Leitungstyp bestimmenden Verunreinigung hat.

8. Verfahren nach Anspruch 5, bei dem der wenigstens eine Vorsprung (12) und eine Halbleiterlage (10b) von der Grenzfläche des Substrats (10) und der Schottky-Elektrode (30) bis zu einer vorgeschriebenen Tiefe eine verhältnismäßig geringe Konzentration einer einen Leitungstyp bestimmenden Verunreinigung in dem zweiten Bereich haben.

9. Verfahren nach einem der Ansprüche 5 bis 8, bei dem der Schritt, der die Schottky-Metallelektrode (30) bildet, weiter aufweist:
Bilden einer Lage (40) hohen Widerstandes oder einer Isolierlage (40), die den zweiten Bereich mit Ausnahme des wenigstens einen Vorsprungbereichs (12) auf dem Substrat (10) bedeckt, vor dem Bilden des Schottky-Metallabschnitts (32), wobei
der Schritt, der den Schottky-Metallabschnitt (32) bildet, darauffolgend ausgeführt wird, um den zweiten Bereich und außerdem den ohmschen Abschnitt (31) und die Lage hohen Widerstands oder die Isolierlage (40) zu bedecken.

## Revendications

1. Procédé de fabrication d'une diode à barrière de Schottky, ledit procédé comprenant les opérations suivantes :
former une électrode en métal ohmique (20) sur une première région d'un substrat semiconducteur (10) ;
former une électrode en métal de Schottky (30) sur une deuxième région, écartée de ladite première région, sur ledit substrat semiconducteur (10) ;
où ledit procédé de formation de l'électrode en métal de Schottky (30) comprend la formation d'au moins une partie ohmique (31) en contact ohmique avec ledit substrat (10) et la formation d'une partie en métal de Schottky (32) qui est en connexion électrique avec ladite ou lesdites parties ohmiques (31),
**caractérisé en ce que** ladite opération de formation de ladite partie en métal de Schottky (32) s'effectue après ladite opération de formation de ladite ou desdites parties ohmiques (31), de façon que ladite partie en métal de Schottky (32) recouvre ladite ou lesdites parties ohmiques (31).

2. Procédé selon la revendication 1, où ledit substrat (10) comprend une configuration du type plaque,
et où ladite première région est placée sur une première surface principale dudit substrat (10),
et ladite deuxième région est placée sur une deuxième surface principale dudit substrat (10).

3. Procédé selon la revendication 1, où :
ledit substrat (10) comprend une configuration du type plaque, et
lesdites première et deuxième régions sont placées sur la même surface principale dudit substrat (10).

4. Procédé selon la revendication 3, où ladite électrode ohmique (20) est formée de façon à entourer ladite électrode de Schottky (30) afin de faire fonction d'anneau de garde.

5. Procédé selon l'une quelconque des revendications précédentes, où ladite opération de formation d'une électrode en métal de Schottky (30) comprend en outre l'opération suivante :
graver de manière anisotrope ladite deuxième région dudit substrat (10), à l'exclusion de la région recouverte par ladite ou lesdites parties ohmiques (31), afin de former au moins une partie saillante (12) dudit substrat (10) au-dessus de ladite ou desdites parties ohmiques (31) avant de former ladite partie en métal de Schottky (32) ; ladite opération de formation d'une partie en métal de Schottky (32) étant effectuée ensuite afin de recouvrir ladite deuxième région et de recouvrir ladite partie ohmique (31).

6. Procédé selon la revendication 5, où ladite ou lesdites parties saillantes (12) comportent une couche transverse (10b) ayant une concentration relativement faible en impureté déterminant le type de conductivité.

7. Procédé selon la revendication 5, où ladite ou lesdites parties saillantes (12) ont une concentration relativement faible en impureté déterminant le type de conductivité.

8. Procédé selon la revendication 5, où ladite ou lesdites parties saillantes (12) et une couche semiconductrice (10b) allant de l'interface dudit substrat (10) et de ladite électrode de Schottky (30) jusqu'à une profondeur prescrite ont une concentration relativement faible en une impureté déterminant le type de conductivité dans ladite deuxième région.

9. Procédé selon l'une quelconque des revendications 5 à 8, où ladite opération de formation d'une électrode en métal de Schottky (30) comprend en outre l'opération suivante :
former une couche de résistance élevée (40) ou une couche isolante (40) couvrant ladite deuxième région à l'exclusion de ladite ou desdites régions de parties saillantes (12) sur ledit substrat (10) avant de former ladite partie en métal de Schottky (32),
ladite opération de formation d'une partie en métal de Schottky (32) étant effectuée ultérieurement afin de recouvrir ladite deuxième région et de recouvrir également ladite partie ohmique (31) et ladite couche de résistance élevée et ou isolante (40).
